# EUROPÄISCHE PATENTANMELDUNG

(11) **EP 3 996 270 A1**
(43) Veröffentlichungstag der Anmeldung: **11.05.2022**
(21) Anmeldenummer: 20206736.9
(22) Anmeldetag: 10.11.2020
(51) Int. Cl.: H02M 7/493, G05F 1/00, H02M 3/158, H02M 1/00

(54) **VERFAHREN ZUM STEUERN EINES STROMRICHTERS**

(71) Anmelder: Wobben Properties GmbH, 26607 Aurich (DE)
(72) Erfinder: HEIN, Yves, 18057 Rostock (DE); ECKEL, Hans-Günter, 18059 Rostock (DE)
(74) Vertreter: Eisenführ Speiser

(57) **Zusammenfassung**

Die vorliegende Erfindung betrifft ein Verfahren zum Steuern eines, insbesondere eine Vielzahl von parallel geschalteten Teilstromrichtern aufweisenden, Stromrichters, umfassend die Schritte: Bestimmen einer Soll-Spannung für den Stromrichter; Unterteilen einer Ausgangsspannung für den Stromrichter in eine Anzahl von, insbesondere gleichen, Spannungsbereichen, wobei die Spannungsbereiche durch eine diskrete obere Spannungsgrenze und eine diskrete untere Spannungsgrenze begrenzt sind; und die Spannungsbereiche durch ein Schalten des Stromrichters, insbesondere der Teilstromrichter, eingestellt werden können; Zuordnen der Sollspannung zu einem, dieser Spannungsbereiche mit einer diskreten oberen Spannungsgrenze und einer diskreten unteren Spannungsgrenze; Zuordnen einer ersten Schalterstellung der unteren Spannungsgrenze; Zuordnen einer zweiten Schalterstellung der oberen Spannungsgrenze; Schalten zwischen der ersten Schalterstellung und der zweiten Schalterstellung so, dass der Stromrichter eine Ist-Spannung erzeugt, die im Wesentlichen der Soll-Spannung entspricht.

## Beschreibung

Die vorliegende Erfindung betrifft ein Verfahren zum Steuern eines Stromrichters sowie einen solchen Stromrichter.

Stromrichter sind ruhende elektrische Geräte bzw. Anlagen zur Umwandlung einer elektrischen Stromart (Gleichstrom, Wechselstrom) in die jeweils andere, oderzurÄnderung charakteristischer Parameter, wie bspw. Spannung und/oder Frequenz.

Stromrichter zur Umwandlung von Wechselstrom in Gleichstrom werden als Gleichrichter bezeichnet.

Stromrichter zur Umwandlung von Gleichstrom in Wechselstrom werden als Wechselrichter bezeichnet.

Stromrichter zur Umwandlung eines ersten Wechselstromes in einen zweiten Wechselstrom werden als Umrichter bezeichnet.

Stromrichter zur Umwandlung einer ersten Gleichspannung in eine zweite Gleichspannung werden als Gleichrichter bezeichnet.

Im Bereich der Erzeuger elektrischer Energie, insbesondere bei Windenergie- oder Photovoltaikanlagen, ist es üblich, mehrere Stromrichter bzw. Stromrichtermodule bzw. Teilstromrichter zu einem Stromrichtersystem parallel zu schalten, insbesondere um die Gesamtleistung zu erhöhen.

Um bspw. zirkulierende Ströme innerhalb dieses Stromrichtersystems zu verhindern, müssen Maßnahmen ergriffen werden, die zugleich nicht die Leistungsabgabe des Stromrichtersystems qualitativ oder quantitativ mindern.

Beim Steuern dieser Stromrichtersysteme sind zudem eine Vielzahl von weiteren Kriterien zu berücksichtigen, wie bspw. die Einhaltung von Grenzwerten für die Zwischenkreisspannung, potentielle Ringströme oder netzseitige Anforderungen.

Nachteilig bei bisher bekannten Verfahren ist, dass keine Koordination der Schalthandlungen über die Grenze der Stromrichtermodule hinaus stattfindet.

Aufgabe der vorliegenden Erfindung ist es daher ein Verfahren zum Steuern von Stromrichtersystemen bereitzustellen, die eine Vielzahl von parallelen geschalteten Teilstromrichtern aufweisen. Zumindest soll aber eine Alternativ zu bisher Bekanntem bereitgestellt werden.

Erfindungsgemäß wird somit ein Verfahren zum Steuern eines, insbesondere eine Vielzahl von parallel geschalteten Teilstromrichtern aufweisenden, Stromrichters, vorgeschlagen.

Der Stromrichter ist dabei bevorzugt als Wechsel- oder Umrichtersystem ausgebildet und umfasst eine Vielzahl von Teilwechselrichtern bzw. Teilwechselrichtermodulen oder Teilumrichtern bzw. Teilumrichtermodulen, die parallel miteinander verschaltet sind, insbesondere um die Leistungsabgabe der einzelnen Teile bzw. Module so aufzusummieren, dass die Gesamtleistung des Stromrichters, also des Wechselrichters oder des Umrichters, erhöht wird.

Der Stromrichter weist zudem eine Steuereinheit auf, die eine Steuerung umfasst, die den Steuervorrichtungen der einzelnen Teilstromrichter übergeordnet ist. Der Stromrichter weist also eine hierarchisch aufgebaute Steuerstruktur auf. Bevorzugt sind die einzelnen Teilstromrichter zudem DC-seitig gekoppelt und AC-seitig entkoppelt. Der Stromrichter weist also AC-seitig bevorzugt nur parasitäre Induktivitäten auf. Die AC-seitige Entkopplung ist also bspw. wenigstens um den Faktor 10 größer als die DC-seitige Entkopplung.

Der Stromrichter ist zudem eingangsseitig wenigstens mit einem Erzeuger elektrischer Energie verbunden, bspw. mit einem Windenergieanlagengenerator indirekt über einen Gleichspannungszwischenkreis und einem Gleichrichter oder mit einer Photovoltaik über einen Gleichspannungszwischenkreis.

Bevorzugt ist die Steuereinheit wie nachstehend beschrieben ausgeführt.

Zum Steuern eines solchen, eine Vielzahl von parallel geschalteten Teilstromrichter aufweisenden, Stromrichters wird nun ein Verfahren vorgeschlagen, umfassend die Schritte: Bestimmen einer Soll-Spannung für den Stromrichter; Unterteilen einer Ausgangsspannung für den Stromrichter in eine Anzahl von, insbesondere gleichen, Spannungsbereichen, wobei die Spannungsbereiche durch eine diskrete obere Spannungsgrenze und eine diskrete untere Spannungsgrenze begrenzt sind und die Spannungsbereiche durch ein Schalten des Stromrichters, insbesondere der Teilstromrichter, eingestellt werden können; Zuordnen der Sollspannung zu einem, dieser Spannungsbereiche mit einer diskreten oberen Spannungsgrenze und einer diskreten unteren Spannungsgrenze; Zuordnen einer ersten Schalterstellung der unteren Spannungsgrenze; Zuordnen einer zweiten Schalterstellung der oberen Spannungsgrenze; Schalten zwischen der ersten Schalterstellung und der zweiten Schalterstellung so, dass der Stromrichter eine Ist-Spannung erzeugt, die im Wesentlichen der Soll-Spannung entspricht.

In einem ersten Schritt wird also zunächst eine Soll-Spannung für den Stromrichter bestimmt. Dies kann bspw. durch eine, der Steuereinheit des Stromrichters übergeordnete Windenergieanlagesteuerung erfolgen.

Zudem wird eine, dem Stromrichter zur Verfügung stehende Ausgangsspannung bestimmt. Dies erfolgt bspw. über ein Messen der Zwischenkreisspannung oder durch ein weiteres Signal oder ist als fester Wert in der Steuereinheit des Stromrichters hinterlegt. Die Ausgangsspannung kann dabei in Form eines Sollwertes und eines Istwertes verwendet werden.

In einem weiteren Schritt wird diese Zwischenkreisspannung in eine Anzahl von gleichen, insbesondere gleichgroßen, Spannungsbereichen unterteilt, bspw. in 10mal 100 Volt.

Diese Spannungsbereiche sind jeweils durch eine diskrete obere Spannungsgrenze und eine diskrete untere Spannungsgrenze begrenzt, bspw. 300 Volt als untere Spannungsgrenze und 400 Volt als obere Spannungsgrenze. Die untere Spannungsgrenze bildet zudem bevorzugt die obere Spannungsgrenze eines weiteren Spannungsbereiches, der unterhalb dieses Spannungsbereiches liegt. Die obere Spannungsgrenze bildet zudem bevorzugt die untere Spannungsgrenze eines weiteren Spannungsbereiches, der oberhalb dieses Spannungsbereiches liegt. Die, einem Spannungsbereich zugeordnete obere und untere Spannungsgrenze, werden auch als benachbarte Spannungsgrenzen bezeichnet.

In einem weiteren Schritt wird die Sollspannung einem Spannungsbereich zugeordnet. Bspw. beträgt die Sollspannung 350 Volt und wird somit dem Spannungsbereich 300/400 Volt zugeordnet.

In einem weiteren Schritt wird dann der unteren und der oberen Spannungsgrenze, also bspw. 300 Volt und 400 Volt, dieses Spannungsbereiches jeweils eine Schalterstellung, insbesondere eines Schalters eines Stromrichters bzw. eines Teilstromrichters, zugeordnet.

Anschließend wird zwischen diesen Schalterstellungen mit einer Taktfrequenz so geschaltet, dass der Stromrichter eine Ist-Spannung erzeugt, die im Wesentlichen der Soll-Spannung von bspw. 350 Volt entspricht.

In einer Ausführungsform erfolgt das Schalten zwischen der ersten Schalterstellung und der zweiten Schalterstellung in Abhängigkeit aller Ausgangsströme.

Hierfür werden bspw. alle Ausgangsströme aller Teilstromrichter erfasst und an die Steuereinheit übergeben.

Das Verfahren umfasst also ferner den Schritt: Ermitteln aller Ausgangsströme, insbesondere eines jeden Teilstromrichters.

Aus diesen so erfassten Ausgangsströmen wird anschließend eine Differenz gebildet, die beim Schalten berücksichtigt wird.

Das Verfahren umfasst also ferner auch den Schritt: Bestimmen einer Differenz aus einem höchsten Ausgangsstrom eines Teilstromrichters und eines niedrigsten Ausgangstromes.

Es wird dabei insbesondere vorgeschlagen, die Differenz zwischen einem höchsten Ausgangsstrom eines Teilumrichters und dem niedrigsten Ausgangsstrom eines Teilumrichters zu ermitteln, und in Abhängigkeit dieser Differenz Schalthandlungen vorzunehmen, insbesondere so, dass die Differenz kleiner, bevorzugt zu Null, wird. Wenn also bspw. diese Differenz eine gewisse Schwelle überschreitet, erfolgt eine Umschaltung.

Vorzugsweise umfasst das Verfahren ferner den Schritt: Vorgebens eines Grenzwertes für die Differenz und Durchführen des Schaltens bei Überschreiten des Grenzwertes.

Es wird also insbesondere vorgeschlagen, einen bestimmten Grenzwert für die Differenz, insbesondere die Differenz zwischen einem höchsten Ausgangsstrom eines Teilumrichters und dem niedrigsten Ausgangsstrom eines Teilumrichters, vorzugeben und bei Überschreiten dieses Grenzwertes, zu schalten.

Das Schalten erfolgt dabei insbesondere so, dass die Differenz kleiner wird, insbesondere zu Null wird.

In einer weiteren Ausführungsform erfolgt das Schalten zwischen der ersten Schalterstellung und der zweiten Schalterstellung in Abhängigkeit einer Spannung.

Es wird also auch vorgeschlagen, dass zusätzlich oder alternativ die Ausgangsspannung berücksichtigt wird.

Vorzugsweise umfasst das Verfahren also ferner den Schritt: Bestimmen einer Spannung aus der ersten Schalterstellung und/oder der zweiten Schalterstellung.

Vorzugsweise wird ein Spannungsfehler durch einen Vergleich der Ist-Spannung mit der Soll-Spannung bestimmt.

Es wird also insbesondere auch vorgeschlagen, die Ist-Spannung des Stromrichters zu erfassen und diese mit der Soll-Spannung des Stromrichters abzugleichen und den daraus resultierenden Spanungsfehler beim Schalten zu berücksichtigen.

Vorzugsweise wird der Spannungsfehler zu einem virtuellen Flussfehler aufintegriert.

Durch das Verwenden des virtuellen Flusses als Größe kann insbesondere die Problematik adressiert werden, in der sich der Stromrichter oder ein Teilstromrichter oder ein Schalter jener (Teil-)Stromrichter zwischen zwei Schaltzuständen befindet. Der virtuelle Fluss ermöglicht eine Implementierung in Form eines I-Reglers, der die Regelabweichung zu Null werden lässt. Der I-Regler stellt dabei sicher, dass sich der Mittelwert genau dort befindet, wo er sein soll, also keine Regelabweichung.

Vorzugsweise erfolgt das Schalten zusätzlich unter Berücksichtigung eines Grenzwertes, insbesondere eines Grenzwertes für den virtuellen Flussfehler.

In einer noch weiteren Ausführungsform erfolgt das Schalten unter Berücksichtigung einer Stromdifferenz.

Es wird also auch vorgeschlagen, dass zusätzlich oder alternativ eine Stromdifferenz berücksichtigt wird.

Vorzugsweise umfasst das Verfahren ferner die Schritte: Bestimmen eines ersten Ist-Stromes eines ersten Einzelstromrichters des Stromrichters und Bestimmen eines zweiten Ist-Stromes eines zweiten Einzelstromrichters des Stromrichters und Bestimmen der Stromdifferenz aus dem ersten Ist-Strom und dem zweiten Ist-Strom.

Es wird also insbesondere vorgeschlagen, dass die Ist-Ströme der Einzelstromrichter mit einander verglichen werden bzw. die Ist-Ströme der Einzelstromrichter beim Schalten berücksichtigt werden.

Vorzugsweise erfolgt das Schalten mit einer festen Taktfrequenz, insbesondere fürwenigstens eine Periode einer Schaltfrequenz.

Vorzugsweise umfasst das Schalten mit einer festen Taktfrequenz eine relative Einschaltzeit.

Vorzugsweise wird bei Überschreiten einer Grenze, insbesondere der oberen oder unteren Spannungsgrenze, ein neuer Schaltzustand verzögerungsfrei eingestellt.

Erfindungsgemäß wird ferner eine Steuereinheit für einen Stromrichter vorgeschlagen, der mehrere parallel geschaltete Einzelstromrichter zum Erzeugen jeweils eines Ausgangswechselstromes umfasst, die jeweils eine Steuervorrichtung aufweisen und dazu eingerichtet sind, jeweils eine Ausgangswechselspannung mittels der Steuervorrichtung in diskreten Schaltzuständen (-1, +1) zu erzeugen, umfassend: eine, den Steuervorrichtungen übergeordnete Steuerung, die dazu eingerichtet ist: eine Soll-Ausgangsspannung für den Stromrichter vorzugeben, wobei die Soll-Ausgangsspannung zwischen zwei diskret-einstellbaren Ausgangsspannungen (k, k+1) liegt und eine Auswahl zwischen eine der beiden Ausgangsspannungen (k, k+1) zu treffen, wobei die Auswahl in Abhängigkeit wenigstens einem der nachfolgenden Liste, umfassend: der Ausgangswechselströme der Einzelstromrichter oder eines aufintegrierten Spannungsfehlers oder einer Soll-Spannung, und der Schaltzustände und der Ausgangsströme der Einzelstromrichter erfolgt.

Vorzugsweise erfolgt die Auswahl zwischen den beiden Ausgangspannungen (k, k+1), in dem die größte Differenz zwischen den Ausgangswechselströmen der Einzelumrichter mit einer Hystereseschwelle verglichen wird und beim Überschreiten dieser Hystereseschwelle derart umgeschaltet wird, dass dadurch diese größte Differenz kleiner wird.

Vorzugsweise ist die Steuereinheit auch dazu eingerichtet ist, einen Umschaltvorgang bei wenigstens einem Einzelstromrichter zu erzeugen, wenn der Einzelstromrichter einen Ausgangswechselstrom erzeugt, der einen maximal-zulässigen Ausgangswechselstrom überschreitet.

Vorzugsweise erfolgt die Auswahl zwischen den beiden Ausgangspannungen (k, k+1), in dem eine Differenz aus der sich aus Ist-Schaltzustände der Einzelumrichter ergebenen rechnerischen Ist-Ausgangsspannung und Soll-Ausgangsspannung über die Zeit aufintegriert wird und ein daraus berechneter virtueller Fluss mit einer Toleranzbandschwelle verglichen wird und beim Überschreiten dieser Toleranzbandschwelle auf die andere Ausgangsspannung (k, k+1) umgeschaltet wird, wobei die Auswahl des umzuschaltenden Einzelumrichters so erfolgt, dass eine maximale Differenz der Ausgangsströme der Teilumrichter kleiner wird.

Vorzugsweise erfolgt zusätzlich eine Umschaltung zwischen den beiden Ausgangsspannungen (k, k+1), wenn eine maximale Differenz zwischen den Ausgangswechselströmen der Einzelumrichter einen Grenzwert überschreitet, wobei ein Einzelumrichter umgeschaltet wird, bei dem diese Umschaltung zu einer Reduktion einer maximalen Differenz zwischen den Ausgangswechselströmen der Einzelumrichter führt.

Vorzugsweise wird für einen festen Zeitbereich ein Anteil der Zeit, in dem die eine und die andere der beiden Ausgangsspannungen ausgewählt worden ist, vorab so berechnet, dass als Mittelwert der Ausgangsspannungen über diesen Zeitbereich eine Soll-Ausgangsspannung erreicht wird.

Vorzugsweise wird, wenn eine Soll-Ausgangsspannung den nächstliegenden diskret einstellbaren Spannungswert überschreitet, unverzögert und unabhängig vom momentanen Zustand eine der beiden Ausgangsspannungen eingestellt.

Vorzugsweise wird, wenn eine Soll-Ausgangsspannung einen nächstliegenden diskret einstellbaren Spannungswert überschreitet, unverzögert ein weiterer Einzelumrichter umgeschaltet.

Vorzugsweise folgt die Umschaltung zwischen den beiden Ausgangspannungen dabei mit dem Einzelumrichter bzw. mit den Einzelumrichtern, bei denen eine Umschaltung zu einer Minimierung einer maximalen Differenz der Ausgangsströme der Einzelumrichter erzielt wird.

Die vorliegende Erfindung wird nun nachfolgend und anhand von begleitenden Figuren näher erläutert, wobei für gleiche oder ähnliche Bauteile oder Baugruppen dieselben Bezugszeichen verwendet werden.
- Fig. 1: zeigt schematisch und exemplarisch eine perspektivische Ansicht einer Windenergieanlage in einer Ausführungsform.
- Fig. 2: zeigt schematisch und exemplarisch einen Aufbau eines elektrischen Stranges einer Windenergieanlage in einer Ausführungsform.
- Fig. 3: zeigt schematisch und exemplarisch den Aufbau eines Wechselrichters.
- Fig. 4: zeigt schematisch und exemplarisch den Aufbau einer Steuereinheit für einen Stromrichter.
- Fig. 5: zeigt schematisch und exemplarisch eine Darstellung diskret-einstellbarer Ausgangsspannungen für eine Soll-Ausgangsspannung.
- Fig. 6: zeigt das Schalterverhalten von mehreren Teilstromrichtern gemäß einer Ausführungsform.
- Fig. 7A: zeigt diskret-einstellbare Ausgangsspannungen für eine Fluss-Regelung.
- Fig. 7B: zeigt einen Regler für eine Fluss-Regelung.
- Fig. 7C: zeigt das Schaltverhalten für eine Fluss-Regelung.
- Fig. 8: zeigt den Ablauf 800 eines Verfahrens zum Steuern eines Stromrichters.

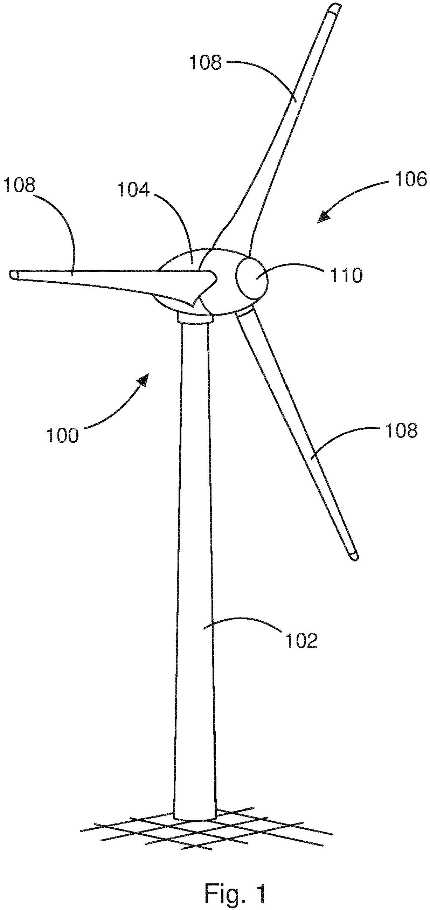

Fig. 1 zeigt eine perspektivische Ansicht einer Windenergieanlage 100.

Die Windenergieanlage 100 weist hierzu einen Turm 102 und eine Gondel 104 auf. An der Gondel 104 ist ein aerodynamischer Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 der Windenergieanlage 100 an. Der Generator erzeugt hierdurch einen einzuspeisenden Strom, der mittels eines Stromrichters in ein elektrisches Versorgungnetz eingespeist wird.

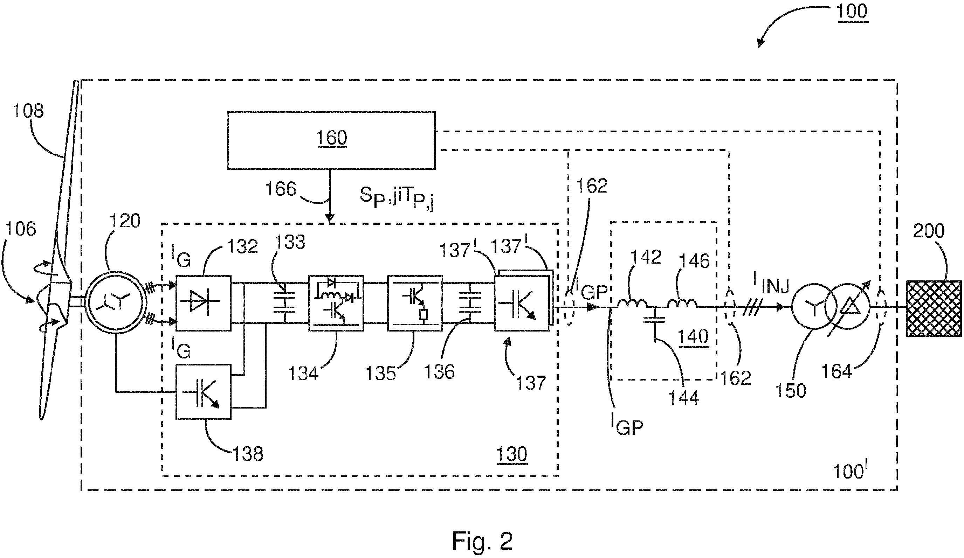

Fig. 2 zeigt schematisch und exemplarisch einen Aufbau eines elektrischen Stranges 100' einer Windenergieanlage 100 in einer Ausführungsform.

Die Windenergieanlage 100 umfasst einen aerodynamischen Rotor 106 mit drei Rotorblättern 108, der mit dem elektrischen Strang 100' der Windenergieanlage mechanisch verbunden ist.

Der elektrische Strang 100' umfasst einen Generator 120, einen Umrichter 130, eine Netzschutzeinrichtung 140, einen Transformator 150, der mit einem elektrischen Versorgungsnetz 200 verbunden ist und eine Steuereinheit 160.

Der aerodynamische Rotor 106 ist dazu eingerichtet, aus Wind eine mechanische Drehbewegung zu erzeugen.

Diese mechanische Drehbewegung wird an den Generator 120 übergeben, bspw. mittels einer Welle.

Der Generator 120, der bevorzugt als 6-phasiger Ringgenerator ausgeführt ist, ist dazu eingerichtet, aus dieser mechanischen Drehbewegung eine elektrische Energie zu erzeugen, insbesondere in Form eines mehrphasigen Wechselstromes, bspw. eines dreiphasigen oder zweimal-dreiphasigen Wechselstromes.

Dieser mehrphasige Wechselstrom wird an einem Umrichter 130 übergeben, um diesen mittels der Netzschutzeinrichtung 140 und dem Transformator 150 in das elektrische Versorgungsnetz 200 einzuspeisen.

Der Umrichter 130 umfasst hierfür im Wesentlichen einen Gleichrichter 132, einen ersten Gleichspannungszwischenkreis 133, einen Hochsetzsteller 134, einen Chopper 135, einen zweiten Gleichspannungszwischenkreis 136 und einen Wechselrichter 137.

Um den, vom Generator 120 erzeugten Strom I_{G} in einen einzuspeisenden Strom l_{g} umzuwandeln, weist der Umrichter 130 an einem Eingang einen Gleichrichter 132 auf, bspw. einen passiven Diodengleichrichter.

Der Gleichrichter 132 ist mit einem ersten Gleichspannungszwischenkreis 133 verbunden. Der erste Gleichspannungszwischenkreis 133 ist mit einem Hochsetzsteller 134 verbunden. Der Hochsetzsteller 134 ist mit einem Chopper 135 verbunden. Der Chopper 135 ist mit einem zweiten Gleichspannungszwischenkreis 136 verbunden. Der zweite Gleichspannungszwischenkreis 136 ist mit dem Wechselrichter 137 verbunden.

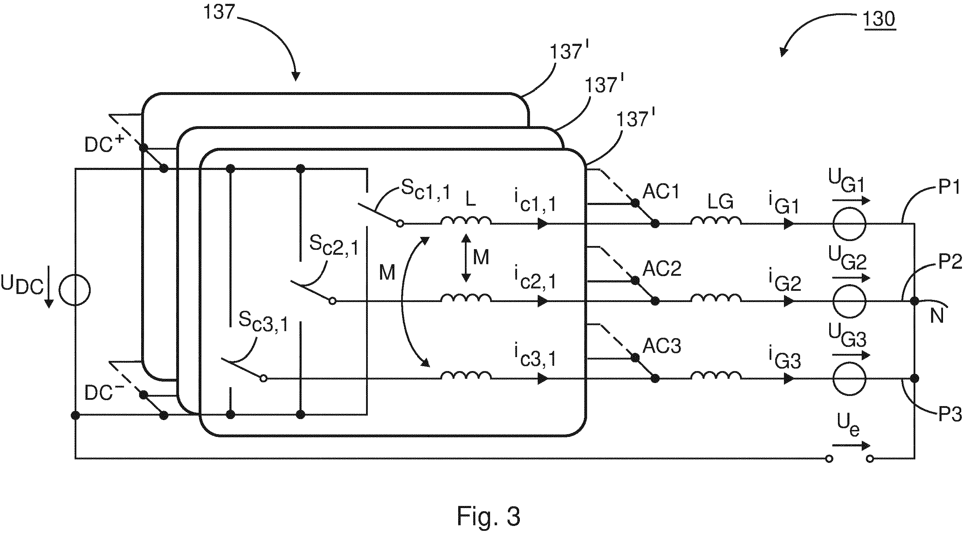

Der Wechselrichter 137 ist mit der Netzschutzeinrichtung 140 verbunden und besteht aus einer Vielzahl von parallel geschalteten Teilwechselrichtern bzw. Wechselrichtermodulen 137', wie bspw. in Fig. 3 gezeigt, die einen Gesamtstrom igp. Der Wechselrichter bildet zugleich den Ausgang des Umrichters 130 aus. Der Wechselrichter ist zudem mit der Netzschutzeinrichtung 140 verbunden.

Die Netzschutzeinrichtung 140 umfasst beispielsweise eine Entkopplungsdrossel 142, einen Filter 144 und eine Netzdrossel 146. In einer bevorzugten Ausführungsform ist die Netzschutzeinrichtung 140 als LCL-Filter ausgebildet. Die Netzschutzeinrichtung 140 ist zudem über einen Windenergieanlagentransformator 150 mit dem elektrischen Versorgungsnetz 200 verbunden. Zudem formt die Netzschutzeinrichtung 140 aus dem erzeugten Gesamtstrom i_{gp} einen einzuspeisenden Strom lᵢₙⱼ, also den Strom, den die Windenergieanlage in das elektrische Versorgungsetznetz 200, bspw. über einen Transformator, einspeist.

Um den einzuspeisenden Strom lᵢₙⱼ in das elektrische Versorgungnetz 200 einzuspeisen, ist ein Windenergieanlagentransformator 150 vorgesehen, der bevorzugt im Stern-Dreieck geschaltet ist.

Das elektrische Versorgungsnetz 200, an das die Windenergieanlage 100 mittels des Transformators 150 angeschlossen ist, kann beispielsweise ein Windparknetz sein oder ein elektrisches Versorgungs- oder Verteilnetz.

Zum Steuern des elektrischen Stranges 100' ist ferner eine Steuereinheit 160 vorgesehen.

Die Steuereinheit 160 ist dazu eingerichtet, den erzeugten Gesamtstrom i_{gp} und/oder den einzuspeisenden Strom lᵢₙⱼ mittels eines Stromerfassungsmittels 162 zu erfassen. Bevorzugt werden insbesondere die Ströme eines jeden Wechselrichtermoduls 137' in jeder Phase erfasst.

Zudem weist die Steuereinheit auch Spannungserfassungsmittel 164 auf, die dazu eingerichtet sind, eine Netzspannung des elektrischen Versorgungnetzes 200 zu erfassen.

In einer besonders bevorzugten Ausführungsform ist die Steuereinheit 160 zudem dazu eingerichtet, auch den Phasenwinkel und die Amplitude des einzuspeisenden Stromes lᵢₙⱼ zu erfassen.

Aus den so erfassten Werten bestimmt die Steuereinheit 160 anschließend mittels eines vorstehend oder nachstehend beschriebenen Verfahrens die Schalterstellungen S_{p,j} der einzelnen Schaltmittel der Wechselrichter.

Die Steuereinheit 160 kann Bestandteil einer Windenergieanlagensteuereinheit oder als separate Baugruppe ausgeführt sein. In einer besonders bevorzugten Ausführungsform ist die Steuereinheit 160 zudem dazu eingerichtet, einen Phasenwinkel ϕ und eine Amplitude î des einzuspeisenden Stromes lᵢₙⱼ zu erfassen.

Aus den so erfassten Werten bestimmt die Steuereinheit 160 anschließend mittels eines vorstehend oder nachstehend beschriebenen Verfahrens die Schalterstellung S_{p,j} jedes Teilwechselrichters 137'.

Fig. 3 zeigt schematisch und exemplarisch den Aufbau eines Wechselrichters, insbesondere eines Teilwechselrichters 137' bzw. Wechselrichtermoduls 137' , wie in Figur 2 gezeigt.

Der Wechselrichter 137 ist Bestandteil eines Umrichters 130 und umfasst drei Teilwechselrichter bzw. Wechselrichtermodule 137', die stellvertretend für eine Vielzahl von Wechselrichtermodulen 1, 2, ..., n stehen.

Die Wechselrichtermodule 137' sind gleichspannungsseitig über einen gemeinsamen Gleichspannungszwischenkreis mit einer Zwischenkreisgleichspannung U_{DC} verbunden.

Die Zwischenkreisgleichspannung U_{DC} weist ein positives Potential DC⁺ und ein negatives Potential DC⁻ auf, die dem Betrage nach bevorzugt im Wesentlichen gleich groß sind.

Ferner sind die Wechselrichtermodule 137' wechselspannungsseitig über ein dreiphasiges Wechselspannungsnetz mit den drei Phasen P1, P2, P3 verbunden. Die drei Phasen P1, P2, P3 können dabei auch vereinfacht als Phase p mit fortlaufender Nummerierung verstanden werden.

Die Phasen P1, P2, P3 weisen jeweils eine Induktivität L sowie eine magnetische Kopplung M auf, und sind im Stern mittels eines Sternpunktes N geschaltet, der bevorzugt einen Neutralleiter mit einer Spannung Uₑ führt.

Jedes Wechselrichtermodul 137' weist jeweils einen Schalter S_{cp,j} für jede Phase p auf, wobei die Schalter S_{c1,1}, S_{c2,1} und S_{c3,1} jeweils die diskreten Werte +1 und -1 einnehmen können. Hierdurch erzeugt jedes Wechselrichtermodul 137' einen Strom i_{c1,j} pro Phase p. Das erste Wechselrichtermodul erzeugt also in der ersten Phase P1 den Strom i_{c1,1}, in der zweiten Phase P2 den Strom i_{c2,1} und in der dritten Phase P3 den Strom i_{c3,1}. Das zweite Wechselrichtermodul erzeugt dann in der ersten Phase P1 den Strom i_{c1,2}, in der zweiten Phase P2 den Strom i_{c2,2} und in der dritten Phase P3 den Strom i_{c3,2} usw.

Diese so erzeugten Ströme i_{cp,j} werden phasenweise mittels der Knotenpunkte AC1, AC2, AC3 zu jeweils einem Summenstrom i_{g,1}, i_{g,2}, i_{g,3} zusammengeführt, die den Gesamtstrom i_{gp} ergeben.

Jede Phase P1, P2, P3 weist zudem eine Gesamtinduktivität Lg sowie eine Spannung U_{g1}, U_{g2}, U_{g3} auf.

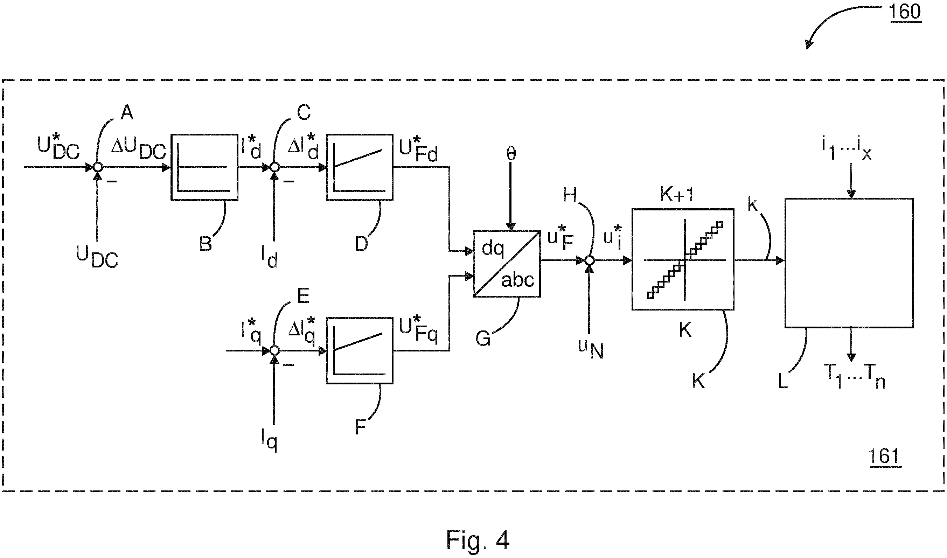

Fig. 4 zeigt schematisch und exemplarisch den Aufbau einer Steuereinheit 160 für einen Stromrichter, insbesondere für einen Wechselrichter 137, wie bspw. in Fig. 2 gezeigt.

Die Steuereinheit 160 umfasst eine, den Steuervorrichtungen übergeordnete Steuerung 161.

Die übergeordnete Steuerung 161 ist dazu eingerichtet, eine Soll-Ausgangsspannung uᵢ* für einen Stromrichter, insbesondere für den in Fig. 2 gezeigten Wechselrichter 137, vorzugeben.

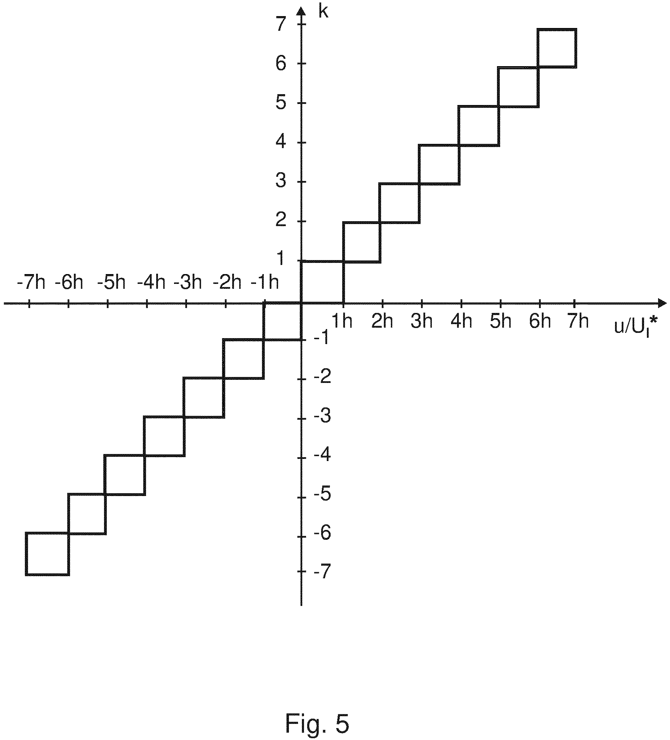

Die Soll-Ausgangsspannung uᵢ* für den Stromrichter liegt dabei bevorzugt zwischen zwei diskret-einstellbaren Ausgangsspannungen k, k+1, wie bspw. detailliert in Fig. 5 gezeigt.

Die Steuereinheit 161 umfasst einen ersten Spannungsabgleich A, einen ersten Spannungsregler B, einen ersten Stromabgleich C, einen ersten Stromregler D, einen zweiten Stromabgleich E, einen zweiten Stromregler F, eine Transformation G, einen zweiten Spannungsabgleich H, diskrete Spannungswerte K und eine Ansteuerung L.

Der Spannungsabgleich A ermittelt aus einer Zwischenkreissollspannung U_{DC}* und einer Zwischenkreisistspannung U_{DC} eine Gleichspannungsabweichung ΔU_{DC}.

Die Gleichspannungsabweichung ΔU_{DC} wird einem ersten Spannungsregler B übergeben.

Der erste Spannungsregler B ist bevorzugt als P-Regler ausgeführt und erzeugt aus der Gleichspannungsabweichung ΔU_{DC} einen Sollstrom I*_{d} für die d-Koordinate des Wechselrichters.

Der Sollstrom I*_{d} für die d-Koordinate des Wechselrichters wird einem ersten Stromabgleich C übergeben.

Der erste Stromabgleich C ermittelt aus dem Sollstrom I*_{d} für die d-Koordinate des Wechselrichters und einem Iststrom I_{d} der d-Koordinate des Wechselrichters eine erste Stromabweichung ΔI_{d}*.

Die erste Stromabweichung ΔI_{d}* wird einem ersten Stromregler D übergeben.

Der erste Stromregler D ist bevorzugt als PI-Regler ausgeführt und erzeugt aus der ersten Stromabweichung ΔI_{d}* eine erste Sollspannung U_{Fd}* für die d-Koordinate des Wechselrichters.

Die erste Sollspannung U_{Fd}* für die d-Koordinate des Wechselrichters wird der Transformation G übergeben.

Ferner ermittelt der zweite Stromabgleich E aus einem Sollstrom I*_{q} für die q-Koordinate des Wechselrichters und einem Iststrom I_{q} der q-Koordinate des Wechselrichters eine zweite Stromabweichung ΔI_{q}*.

Die zweite Stromabweichung ΔI_{q}* wird einem zweiten Stromregler F übergeben.

Der zweite Stromregler D ist bevorzugt als PI-Regler ausgeführt und erzeugt aus der zweiten Stromabweichung ΔI_{q}* eine zweite Sollspannung U_{Fq}* für die d-Koordinate des Wechselrichters.

Die zweite Sollspannung U_{Fq}* für die q-Koordinate des Wechselrichters wird der Transformation G übergeben.

Die Transformation G transformiert die erste Sollspannung U_{Fd}* und die zweite Sollspannung U_{Fq}* unter Berücksichtigung eines elektrischen Winkels θ in einen dritten Spannungssollwert U_{F}* in abc-Koordinaten.

Der dritte Spannungssollwert U_{F}* wird in einem zweiten Spannungsabgleich mit der erzeugten Gesamtspannung u_{N} aller N Wechselrichtermodule abgeglichen, um die Soll-Ausgangsspannung uᵢ* für den Wechselrichter zu erzeugen.

Aus der Soll-Ausgangsspannung uᵢ* wird mittels der diskreten Spannungswerte eine Schalterstellung k ausgewählt und an die Ansteuerung L ausgegeben.

Dies Ansteuerung L ermittelt unter Berücksichtigung aller Ströme aller Phasen aller Umrichtermodule die entsprechenden Schaltbefehle Tcp,j, also T₁, ..., Tₙ.

Fig. 5 zeigt schematisch und exemplarisch eine Darstellung 500 diskret-einstellbarer Ausgangsspannungen für eine Soll-Ausgangsspannung, insbesondere wie im Block K der Figur 4 gezeigt.

In der Darstellung sind die Schaltzustände k über der Spannung u abgetragen.

Zunächst wird die zur Verfügung stehende Zwischenkreisgleichspannung in N gleiche Spannungsbereiche unterteilt, bspw. 14 Spannungsbereiche.

Diese 14 Spannungsbereiche sind jeweils durch mögliche, diskrete Ausgangsspannungen nach oben und nach unten abgegrenzt. Dies bedeutet insbesondere, dass durch die Schaltzustände k nur eine Ausgangsspannung am Umrichter eingestellt wird, die auf Grund der diskreten Schaltzustände nur diskrete Werte (auf den Linien) einnehmen kann.

Die Sollausgangspannung uᵢ*, die für den Umrichter bestimmt wird, liegt aber üblicherweise zwischen diesen diskreten Werten.

Um die Sollausgangsspannung uᵢ* trotzdem als Ist-Spannung einzustellen, wird also insbesondere vorgeschlagen, zwischen Schaltzuständen k, k+1, wie vorstehend oder nachstehend beschrieben, hin und her zu schalten.

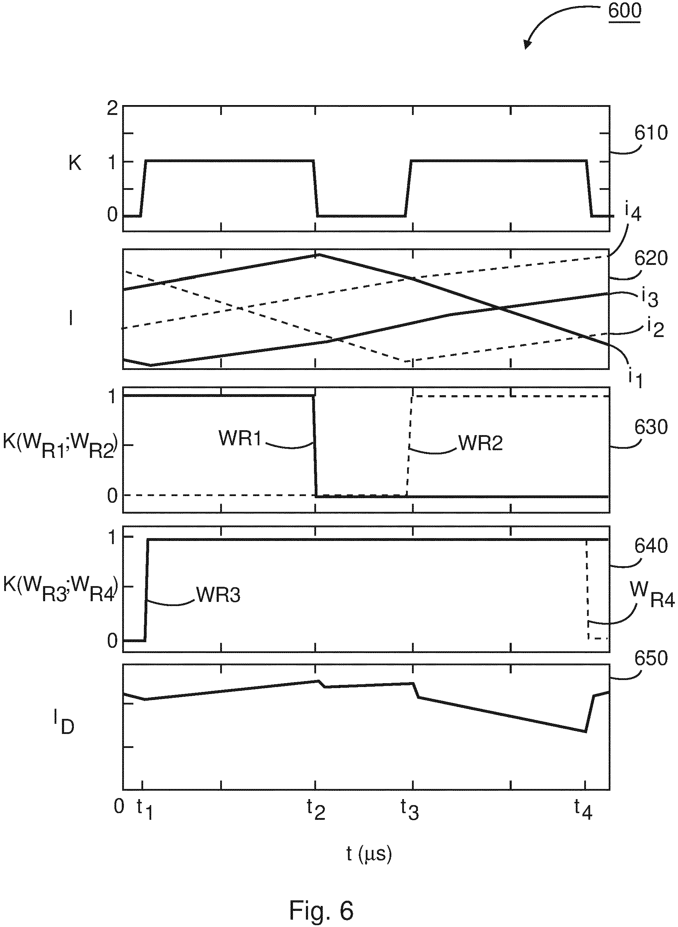

Fig. 6 zeigt das Schalterverhalten 600 von mehreren Teilstromrichter WR1, WR2, WR3, W4 gemäß einer Ausführungsform.

Die Teilstromrichter WR1, WR2, WR3, WR4 sind als Wechselrichter ausgeführt, bspw. als Wechselrichtermodul bzw. Teilwechselrichter, wie in Fig. 2 oder Fig. 3 gezeigt.

Im ersten Diagramm 610 ist der Schaltzustand k über der Zeit abgebildet.

Im zweiten Diagramm 620 sind die Ausgangsströme i₁, i₂, i₃, i₄ der Teilstromrichter WR1, WR2, WR3, WR4 über der Zeit abgebildet.

Im dritten Diagramm 630 sind die Schaltzustände der Teilstromrichter WR1, WR2 abgebildet.

Im vierten Diagramm 640 sind die Schaltzustände der Teilstromrichter WR3, WR4 abgebildet.

Im fünften Diagramm 650 ist der Gesamtstrom i_{D} der Teilstromrichter WR1, WR2, WR3, WR4 abgebildet.

Die fünf Diagramme 610, 620, 630, 640, 650 sind zeitsynchron zueinander.

Um einen Ist-Strom i_{D} zu erreichen, muss die Ansteuerung zwischen den Schaltzuständen k=0 und k=1 hin und her schalten. Dies ist in Diagramm 610 gezeigt.

Zum Zeitpunkt t₁ wird der Schaltzustand von k=0 auf k=1 geändert.

Die Ansteuerung realisiert diesen Schaltzustand k=1 durch ein Umschalten des dritten Teilstromrichters WR3, wie in Diagramm 640 gezeigt.

Zum Zeitpunkt t₂ wird der Schaltzustand wieder von k=1 auf k=0 geändert.

Die Ansteuerung realisiert diesen Schaltzustand k=0 durch ein Umschalten des ersten Teilstromrichters WR1, wie in Diagramm 630 gezeigt.

Zum Zeitpunkt t₃ wird der Schaltzustand wieder von k=0 auf k=1 geändert.

Die Ansteuerung realisiert diesen Schaltzustand k=1 durch ein Umschalten des zweiten Teilstromrichters WR2, wie in Diagramm 630 gezeigt.

Zum Zeitpunkt t₄ wird der Schaltzustand wieder von k=1 auf k=0 geändert.

Die Ansteuerung realisiert diesen Schaltzustand k=0 durch ein Umschalten des vierten Teilstromrichters WR4, wie in Diagramm 640 gezeigt.

Der aus diesen Schaltvorgängen resultierende Strom i_{D} ist im fünften Diagramm 650 abgebildet.

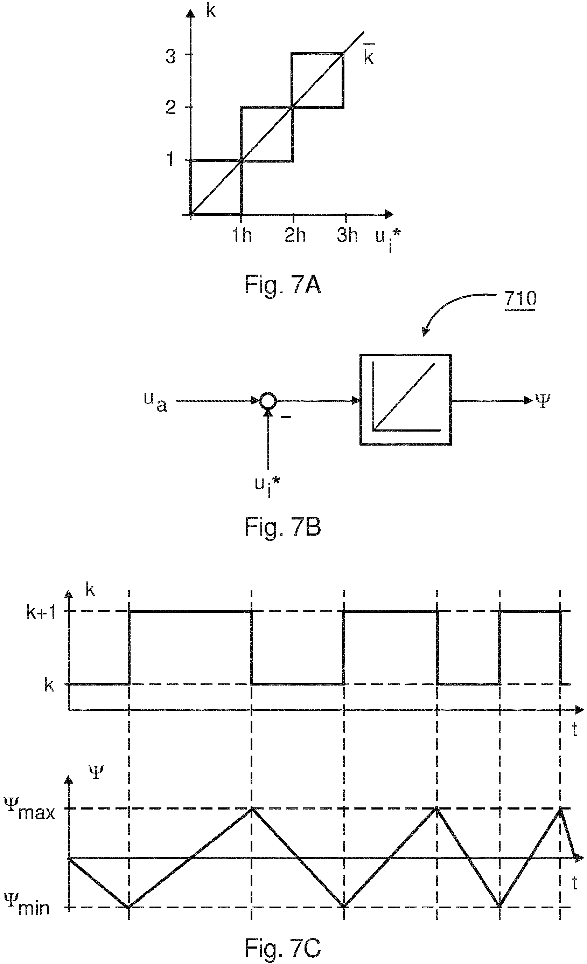

Fig. 7A zeigt diskret-einstellbare Ausgangsspannungen für eine Fluss-Regelung.

Fig. 7B zeigt einen Regler 710 für eine Fluss-Regelung.

Der Regler 710 ist als I-Regler ausgeführt und integriert einen Spannungsfehler aus Ist-Ausgangsspannung uₐ und Soll-Ausgangsspannung uᵢ* auf. Es wird also von der Ist-Ausgangsspannung uₐ die Soll-Ausgangsspannung uᵢ* subtrahiert. Der so ermittelte Spannungsfehler wird aufintegriert und ein virtueller Fluss ψ berechnet.

Fig. 7C zeigt das Schaltverhalten für eine Fluss-Regelung.

Es wird dabei insbesondere vorgeschlagen, dass der Schaltzustand k insbesondere dann geändert wird, wenn es zu einer Überschreitung eines Grenzwertes kommt.

Ein Schaltzustand von k führt zu einem abfallenden Flussfehler. Wenn der Flussfehler einen Grenzwert unterschritten hat, wird auf den Schaltzustand k+1 umgeschaltet. Ein Schaltzustand von k+1 führt zu einem ansteigenden Flussfehler. Wenn der Flussfehler einen Grenzwert überschritten hat, wird auf den Schaltzustand k umgeschaltet. Ein Sollwert in der Mitte von zwei Schaltzuständen führt zu einer schnelleren Änderung des Flussfehlers als ein solcher nahe an einem Schaltzustand, daher ist die resultierende Schaltfrequenz nicht konstant. Sie ist aber unabhängig von der Last. Die maximale Schaltfrequenz kann vorab berechnet werden. Der Grenzwert kann entweder konstant oder von der Sollspannung oder vom Strom abhängig sein.

Optional wird zusätzlich die Stromdifferenz überwacht, wie vorstehend beschrieben, und zum Auslösen zusätzlicher Schaltvorgänge genutzt. Auf diese Weise kann verhindert werden, dass die Ausgangsströme der Einzelstromrichter auseinanderlaufen, wenn der Sollwert der Spannung genau auf einem diskret einstellbaren Spannungsniveau liegt und der Flussfehler daher nicht ansteigt.

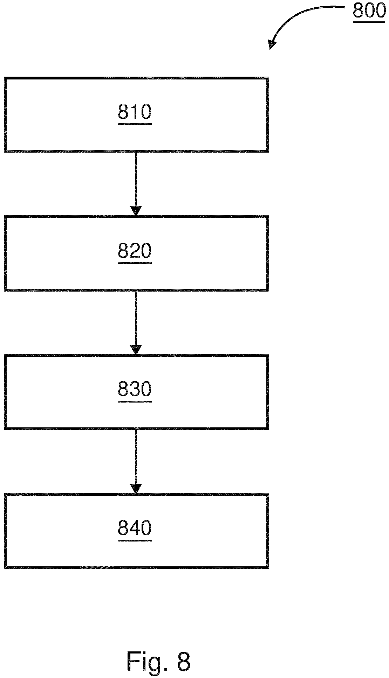

Fig. 8 zeigt den Ablauf 800 eines Verfahrens zum Steuern eines Stromrichters.

In einem ersten Schritt 810 wird eine Soll-Spannung für den Stromrichter bestimmt.

In einem nächsten Schritt 820 wird eine Zwischenkreisspannung des Stromrichters in gleiche Spannungsbereiche unterteilt, wobei die Spannungsbereiche durch eine diskrete obere Spannungsgrenze und eine diskrete untere Spannungsgrenze begrenzt sind.

In einem nächsten Schritt 830 erfolgt ein Zuordnen der Sollspannung zu einem, dieser Spannungsbereiche mit einer diskreten oberen Spannungsgrenze und einer diskreten unteren Spannungsgrenze, ein Zuordnen einer ersten Schalterstellung der unteren Spannungsgrenze und ein Zuordnen einer zweiten Schalterstellung der oberen Spannungsgrenze.

In einem nächsten Schritt 840 erfolgt ein Schalten zwischen der ersten Schalterstellung und der zweiten Schalterstellung mit einer Taktfrequenz so, dass der Stromrichter eine Ist-Spannung erzeugt, die im Wesentlichen der Soll-Spannung entspricht.

### Bezuqszeichenliste

- 100: Windenergieanlage
- 100': elektrischer Strang, insbesondere der Windenergieanlage
- 102: Turm, insbesondere der Windenergieanlage
- 104: Gondel, insbesondere der Windenergieanlage
- 106: aerodynamischer Rotor, insbesondere der Windenergieanlage
- 108: Rotorblatt, insbesondere der Windenergieanlage
- 110: Spinner, insbesondere der Windenergieanlage
- 120: Generator, insbesondere der Windenergieanlage
- 130: Umrichter, insbesondere der Windenergieanlage
- 132: Gleichrichter, insbesondere des Umrichters
- 133: erster Gleichspannungszwischenkreis, insbesondere des Umrichters
- 134: Hochsetzsteller, insbesondere des Umrichters
- 135: Chopper, insbesondere des Umrichters
- 136: zweiter Gleichspannungszwischenkreis, insbesondere des Umrichters
- 137: Wechselrichter, insbesondere des Umrichters
- 137': Teilwechselrichter bzw. Wechselrichtermodul, insbesondere des Umrichters
- 140: Netzschutzeinrichtung, insbesondere der Windenergieanlage
- 150: Transformator, insbesondere der Windenergieanlage
- 160: Steuereinheit, insbesondere der Windenergieanlage
- 161: übergeordnete Steuerung, insbesondere der Steuereinheit
- 200: elektrisches Versorgungsnetz

- 600: Schaltverhalten
- 610: erstes Diagramm
- 620: zweites Diagramm
- 630: drittes Diagramm
- 640: viertes Diagramm
- 650: fünftes Diagramm

- AC: Knotenpunkten aller Leiter einer Phase
- c: Nummer des Teilstromes
- DC⁺: positives Potential, insbesondere der Zwischenkreisgleichspannung
- DC⁻: negatives Potential, insbesondere der Zwischenkreisgleichspannung
- I_{cp,j}: Strom einer Phase eines Wechselrichtermoduls
- I_{d}: Iststrom, insbesondere für eine d-Koordinate
- I*_{d}: Sollstrom, insbesondere für eine d-Koordinate
- Iq,p: Gesamtstrom einer Phase
- I_{q}: Ist-Strom, insbesondere für eine q-Koordinate
- I*_{q}: Soll-Strom, insbesondere für eine q-Koordinate
- I_{gp,j}: Gesamtstrom einer Phase aller Wechselrichtermodule
- I_{G}: Strom des Generators
- I_{gp}: Gesamtstrom des Wechselrichters
- I_{INJ}: Strom der Windenergieanlage, insbesondere einzuspeisender Strom
- i_{g,1}, i_{g,2}, i_{g,3}: Summenstrom
- i₁, i₂, i₃, i₄: Ausgangsströme
- i_{c1,j}, ic_{1,1},: Strom
- i_{c2,1} i_{c3,1}: Strom
- i_{c1,2}, i_{c2,2}, i_{c3,2}: Strom
- î: Amplitude des einzuspeisenden Stromes
- j: Nummer des Teilstromrichters
- k: Schaltzustände
- Lg: Gesamtinduktivität, insbesondere einer Phase
- p: Phase, insbesondere eines Wechselspannungsnetzes
- P1: erste Phase, insbesondere des Wechselspannungsnetzes
- P2: zweite Phase, insbesondere des Wechselspannungsnetzes
- P3: dritte Phase, insbesondere des Wechselspannungsnetzes
- t₁, t₂, t₃, t₄: Zeit
- U_{DC}*: Zwischenkreissollspannung, insbesondere eines Zwischenkreises
- U_{DC}: Zwischenkreisistspannung, insbesondere eines Zwischenkreises
- Uₑ: Spannung, insbesondere des Neutralleiters
- uᵢ*: Soll-Ausgangspannung, insbesondere für einen Stromrichter
- U_{F}*: dritte Sollspannung, insbesondere in abc-Koordinaten
- U_{Fd}*: erste Sollspannung, insbesondere für eine d-Koordinate
- U_{Fq}*: zweite Sollspannung, insbesondere für eine q-Koordinate
- Ug,p: Spannung einer Phase
- S: Schalter, insbesondere einer Phase eines Wechselrichtermoduls
- S_{cp,j}: Schalterstellung, insbesondere eines bestimmten Schalters
- S_{c1,1}: Schalter
- S_{c2,1}: Schalter
- S_{c3,1}: Schalter
- ΔI_{d}*: erste Stromabweichung, insbesondere einer d-Koordinate
- ΔI_{q}*: zweite Stromabweichung, insbesondere einer q-Koordinate
- ΔU_{DC}: Gleichspannungsabweichung
- ϕ: Phasenwinkel des einzuspeisenden Stromes
- θ: elektrischer Winkel
- ψ: virtueller Fluss

- A: erster Spannungsabgleich
- B: erster Spannungsregler
- C: erster Stromabgleich
- D: erster Stromregler
- E: zweiter Stromabgleich
- F: zweiter Stromregler
- G: Transformation
- H: zweiter Spannungsabgleich
- K: diskrete Spannungswerte
- L: Ansteuerung
- WR: Teilstromrichter

## Patentansprüche

1. Verfahren zum Steuern eines, insbesondere eine Vielzahl von parallel geschalteten Teilstromrichtern aufweisenden, Stromrichters, umfassend die Schritte:
- Bestimmen einer Soll-Spannung für den Stromrichter;
- Unterteilen einer Ausgangsspannung für den Stromrichter in eine Anzahl von, insbesondere gleichen, Spannungsbereichen, wobei
- die Spannungsbereiche durch eine diskrete obere Spannungsgrenze und eine diskrete untere Spannungsgrenze begrenzt sind; und
- die Spannungsbereiche durch ein Schalten des Stromrichters, insbesondere der Teilstromrichter, eingestellt werden können;
- Zuordnen der Sollspannung zu einem, dieser Spannungsbereiche mit einer diskreten oberen Spannungsgrenze und einer diskreten unteren Spannungsgrenze;
- Zuordnen einer ersten Schalterstellung der unteren Spannungsgrenze;
- Zuordnen einer zweiten Schalterstellung der oberen Spannungsgrenze;
- Schalten zwischen der ersten Schalterstellung und der zweiten Schalterstellung so, dass der Stromrichter eine Ist-Spannung erzeugt, die im Wesentlichen der Soll-Spannung entspricht.

2. Verfahren nach Anspruch 1, wobei
- das Schalten zwischen der ersten Schalterstellung und der zweiten Schalterstellung in Abhängigkeit aller Ausgangsströme erfolgt, ferner umfassend den Schritt:
- Ermitteln aller Ausgangsströme, insbesondere eines jeden Teilstromrichters und
- Bestimmen einer Differenz aus einem höchsten Ausgangsstrom eines Teilstromrichters und eines niedrigsten Ausgangstromes.

3. Verfahren nach Anspruch 2, wobei
- das Schalten zwischen der ersten Schalterstellung und der zweiten Schalterstellung in Abhängigkeit aller Ausgangsströme erfolgt, ferner umfassend den Schritt:
- Vorgebens eines Grenzwertes für die Differenz; und
- Durchführen des Schaltens bei Überschreiten des Grenzwertes.

4. Verfahren nach Anspruch 1, wobei
- das Schalten zwischen der ersten Schalterstellung und der zweiten Schalterstellung in Abhängigkeit einer Spannung erfolgt, ferner umfassend den Schritt:
- Bestimmen einer Spannung aus der ersten Schalterstellung und/oder der zweiten Schalterstellung.

5. Verfahren nach Anspruch 4, wobei
- das Schalten zwischen der ersten Schalterstellung und der zweiten Schalterstellung in Abhängigkeit einer Spannung erfolgt, ferner umfassend den Schritt:
- Bestimmen eines Spannungsfehlers durch einen Vergleich der Ist-Spannung mit der Soll-Spannung.

6. Verfahren nach Anspruch 5, wobei
- das Schalten zwischen der ersten Schalterstellung und der zweiten Schalterstellung in Abhängigkeit einer Spannung erfolgt, ferner umfassend den Schritt:
- Aufintegrieren des Spannungsfehlers zu einem virtuellen Flussfehler.

7. Verfahren nach einem der vorstehenden Ansprüche, wobei
- das Schalten zusätzlich unter Berücksichtigung eines Grenzwertes erfolgt, insbesondere eines Grenzwertes für den virtuellen Flussfehler.

8. Verfahren nach einem der vorstehenden Ansprüche, wobei
- das Schalten unter Berücksichtigung einer Stromdifferenz erfolgt, ferner umfassend die Schritte:
- Bestimmen eines ersten Ist-Stromes eines ersten Einzelstromrichters des Stromrichters; und
- Bestimmen eines zweiten Ist-Stromes eines zweiten Einzelstromrichters des Stromrichters; und
- Bestimmen der Stromdifferenz aus dem ersten Ist-Strom und dem zweiten Ist-Strom.

9. Verfahren nach einem der vorstehenden Ansprüche, wobei
- das Schalten mit einer festen Taktfrequenz erfolgt, insbesondere für wenigstens eine Periode einer Schaltfrequenz.

10. Verfahren nach Anspruch 9, wobei
- das Schalten mit einer festen Taktfrequenz eine relative Einschaltzeit umfasst.

11. Verfahren nach Anspruch 9 oder 10, wobei
- bei Überschreiten einer Grenze, insbesondere der oberen oder unteren Spannungsgrenze, ein neuer Schaltzustand verzögerungsfrei eingestellt wird.

12. Steuereinheit für einen Stromrichter, der
- mehrere parallel geschaltete Einzelstromrichter zum Erzeugen jeweils eines Ausgangswechselstromes umfasst, die
- jeweils eine Steuervorrichtung aufweisen und dazu eingerichtet sind, jeweils eine Ausgangswechselspannung mittels der Steuervorrichtung in diskreten Schaltzuständen (-1, +1) zu erzeugen
umfassend:
- eine, den Steuervorrichtungen übergeordnete Steuerung, die dazu eingerichtet ist:
- eine Soll-Ausgangsspannung für den Stromrichter vorzugeben, wobei die Soll-Ausgangsspannung zwischen zwei diskret-einstellbaren Ausgangsspannungen (k, k+1) liegt und
- eine Auswahl zwischen eine der beiden Ausgangsspannungen (k, k+1) zu treffen, wobei die Auswahl in Abhängigkeit
- wenigstens einem der nachfolgenden Liste, umfassend:
- der Ausgangswechselströme der Einzelstromrichter oder
- eines aufintegrierten Spannungsfehlers oder
- einer Soll-Spannung,
und
- der Schaltzustände und der Ausgangsströme der Einzelstromrichter erfolgt.

13. Steuereinheit für einen Stromrichter nach Anspruch 12, wobei
- die Auswahl zwischen den beiden Ausgangspannungen (k, k+1) erfolgt, in dem die größte Differenz zwischen den Ausgangswechselströmen der Einzelumrichter mit einer Hystereseschwelle verglichen wird und beim Überschreiten dieser Hystereschwelle derart umgeschaltet wird, dass dadurch diese größte Differenz kleiner wird.

14. Steuereinheit für einen Stromrichter nach Anspruch 12 oder 13, wobei
- die Steuereinheit auch dazu eingerichtet ist, einen Umschaltvorgang bei wenigstens einem Einzelstromrichter zu erzeugen, wenn der Einzelstromrichter einen Ausgangswechselstrom erzeugt, der einen maximal-zulässigen Ausgangswechselstrom überschreitet.

15. Steuereinheit für einen Stromrichter nach einem der Ansprüche 12 bis 14, wobei
- die Auswahl zwischen den beiden Ausgangspannungen (k, k+1) erfolgt, in dem eine Differenz aus der sich aus Ist-Schaltzustände der Einzelumrichter ergebenen rechnerischen Ist-Ausgangsspannung und Soll-Ausgangsspannung über die Zeit aufintegriert wird und ein daraus berechneter virtueller Fluss mit einer Toleranzbandschwelle verglichen wird und beim Überschreiten dieser Toleranzbandschwelle auf die andere Ausgangsspannung (k, k+1) umgeschaltet wird, wobei die Auswahl des umzuschaltenden Einzelumrichters so erfolgt, dass eine maximale Differenz der Ausgangsströme der Teilumrichter kleiner wird.

16. Steuereinheit für einen Stromrichter nach einem der Ansprüche 12 bis 15, wobei
- zusätzlich eine Umschaltung zwischen den beiden Ausgangsspannungen (k, k+1) erfolgt, wenn eine maximale Differenz zwischen den Ausgangswechselströmen der Einzelumrichter einen Grenzwert überschreitet, wobei ein Einzelumrichter umgeschaltet wird, bei dem diese Umschaltung zu einer Reduktion einer maximalen Differenz zwischen den Ausgangswechselströmen der Einzelumrichter führt.

17. Steuereinheit für einen Stromrichter nach einem der Ansprüche 12 bis 16, wobei
- für einen festen Zeitbereich ein Anteil der Zeit, in dem die eine und die andere der beiden Ausgangsspannungen ausgewählt worden ist, vorab so berechnet wird, dass als Mittelwert der Ausgangsspannungen über diesen Zeitbereich eine Soll-Ausgangsspannung erreicht wird.

18. Steuereinheit für einen Stromrichter nach einem der Ansprüche 12 bis 17, wobei
- wenn eine Soll-Ausgangsspannung den nächstliegenden diskret einstellbaren Spannungswert überschreitet, unverzögert und unabhängig vom momentanen Zustand eine der beiden Ausgangsspannungen eingestellt wird.

19. Steuereinheit für einen Stromrichter nach einem der Ansprüche 12 bis 18, wobei
- wenn eine Soll-Ausgangsspannung einen nächstliegenden diskret einstellbaren Spannungswert überschreitet, unverzögert ein weiterer Einzelumrichter umgeschaltet wird.

20. Steuereinheit für einen Stromrichter nach einem der Ansprüche 12 bis 19, wobei
- die Umschaltung zwischen den beiden Ausgangspannungen dabei mit dem Einzelumrichter bzw. mit den Einzelumrichtern, bei denen eine Umschaltung zu einer Minimierung einer maximalen Differenz der Ausgangsströme der Einzelumrichter erzielt wird.
